Europäisches Patentamt

(19) European Patent Office

Office européen des brevets

(11) Publication number: **0 335 629**
A2

# EUROPEAN PATENT APPLICATION

(21) Application number: **89302993.4**

(22) Date of filing: **28.03.89**

(51) Int. Cl.⁴: **G 03 F 7/20**

(30) Priority: **29.03.88 US 174579**

(43) Date of publication of application:
**04.10.89  Bulletin  89/40**

(84) Designated Contracting States:
**AT BE CH DE ES FR GB GR IT LI LU NL SE**

(71) Applicant: **ROHM AND HAAS COMPANY**
**Independence Mall West**
**Philadelphia Pennsylvania 19105  (US)**

(72) Inventor: **Warburton, Charles Edward, Jr.**
**915 Denston Drive**
**Ambler Pennsylvania 19002  (US)**

**Rounds, Nicholas Andrew**
**271 N. Tamemend Avenue**
**New Britain Pennsylvania 18901  (US)**

(74) Representative: **Buckley, Guy Julian et al**
**ROHM AND HAAS (UK) LTD. European Operations Patent**
**Department Lennig House 2 Mason's Avenue**
**Croydon CR9 3NB  (GB)**

(54) Process for preparing photocured coatings.

(57) A two exposure process for producing photocured coatings, such as photoresists, in which a composition containing a photosensitive free radical reactive system and a photosensitive cationic cure epoxy system is exposed in a first stage to a first radiation which initiates reaction in one of said systems and is exposed in a second stage to a second radiation, of different wavelengths, to initiate reaction in the other system. A process for producing images of photocured coating is also disclosed.

EP 0 335 629 A2

## Description

## PROCESS FOR PREPARING PHOTOCURED COATINGS

This invention is concerned with a process for preparing photocured coatings, such as resists. More particularly, though not exclusively, this invention is concerned with a process for preparing photolithographic images.

Thermally cured coatings require large amounts of energy to cure. Photocured coatings are easier to process since they typically cure faster than thermal cure coatings. A process that produces solvent resistant photocured coatings without the need for a thermal cure is desired.

Compositions and processes which employ a photoinitiated reactive system together with a thermally cured system have been disclosed: U.S. Patent 4,479,983, U.S. Patent 3,776,729, U.S. Patent 4,572,890, U.S. Patent 4,377,457. In U.S. Patent 3,776,729 an imaging process is disclosed in which ultraviolet radiation cure of a free-radical reactive system is followed by heat cure of an epoxy. In U.S. Patent 4,572,890 an imaging process is disclosed in which a thermally initiated free radical material is heat cured and the composition is then exposed to cure a photoinitiated epoxy material to form a image.

Photocured compositions containing epoxy resin and a photoinitiator of epoxy cure along with free radical polymerizable material and a free radical photoinitiator are disclosed in U.S. 4,156,035 and Perkins, J., Journal of Radiation Curing, 1981, p. 16 to 23. In these disclosures both the epoxy and the free-radical material are simultaneously cured by exposure to one type of radiation.

German Patent DE 3,516,661 discloses a process for bonding optical glass components with an adhesive composition which contains cycloaliphatic epoxide, bisphenol A epoxide and acrylated epoxide monomers in combination with free radical and cationic photoinitiators, by exposing the adhesive to repeated exposures to the same source of radiation. The first radiation exposure produces a partial cure which permits the alignment of the glass components to be adjusted. When proper alignment is achieved additional exposure to the same radiation completes the cure.

Compositions and processes in which a photosensitive reaction system is exposed in more than one step have been disclosed. For example U.S. Patent 4,291,118 discloses an imaging process in which polyene-polythiol photopolymer is first flood exposed to harden the surface, then image-wise exposed to cure. The areas not exposed in the second stage are removed by solvent.

U.S. Patent 4,416,975 discloses a process in which a composition containing compounds having two types of double bonds having different sensitivity to the action of the photoinitiator are cured in a two-stage exposure using one type of radiation. The duration of the first exposure to the radiation is controlled so that only one of the double bond types is reacted. The second exposure is of longer duration and initiates the other type of double bond. A thermal epoxy cure is an optical final step.

U.S. Patent 4,411,931 and U.S. Patent 4,313,969 disclose processes which employ multiple exposures to radiation of different wavelengths to control surface texture in the cure of thick films or filled coatings. These processes use the different wavelengths of radiation to regulate the depth at which a coating is cured in successive exposures. The lower part of the coating is cured by exposure to one type of radiation and the surface of the coating is cured by exposure to radiation of a different wavelength.

An object of the invention is to provide a process that produces a cured coating on a substrate without the need for a heat cure.

Another object of the invention is to provide a process that produces a tough solvent resistant coating.

An additional object of the invention is to provide such a process that produces a repairable coating as the first desired level of reaction.

Another object of the invention is to provide a process for producing an image of cured coating.

The invention provides a process for producing photocured coatings in a two-step, actinic radiation cure in which a composition containing a first reactive system and a second reactive system is deposited as a coating on a substrate.

The first reactive system contains a free-radical polymerizable material and a photoinitiator of free radical polymerization. The second reactive system contains a cationic polymerizable epoxy resin and a photoinitiator of cationic polymerization.

In a first exposure step, all or portions of the coating are exposed to a first actinic radiation to initiate one of the reactive systems. This first exposure step is followed by a second exposure step in which all or portions of the coating are exposed to a second actinic radiation different than said first actinic radiation to initiate the other reactive system. The portions of the coating exposed to said second actinic radiation may be the same or different portions of the coating exposed to said first actinic radiation. This invention also provides imaging processes.

Note that the first and second actinic radiations are different; the second actinic radiation includes wavelengths that are not in the first radiation. The first actinic radiation does not include an effective amount of radiation at the wavelengths that initiate one of the photoinitiators in the coating composition; whereas the second actinic radiation contains an effective amount of radiation at these wavelengths..

In one embodiment, the free radical polymerization is initiated in the first radiation exposure step to form a thermoplastic coating without substantial crosslinking of the free radical polymerized material or the epoxy resin. The thermoplastic coating (B-stage) is subsequently flood exposed or photolithographically imaged in a second ultraviolet exposure step to form a thermoset crosslinked image on the surface.

In another embodiment a filter is used in the first radiation exposure step to control curing in the liquid coating and to avoid substantial crosslinking. The filter protects the coating from exposure to those wavelengths of actinic light which initiate reaction in one of the reactive systems.

As used in this disclosure, the terms "substantial", "extensive" or "significant" crosslinking refers to an extent or degree of crosslinking which interferes with subsequent processing of the polymer coating, such as the development of an image by impeding the manipulation or removal of portions of polymer coating from the substrate.

## First Reactive System

The first reactive system comprises a free-radical polymerizable material and a photoinitator of free-radical polymerization.

## Free-Radical Polymerizable Material

Examples of the free-radical polymerizable material useful in the invention include multifunctional vinyl oligomers, monofunctional vinyl monomers, and multifunctional vinyl monomers.

## Multifunctional Vinyl Oligomers

"Multifunctional vinyl oligomers" as used herein refers to relatively low molecular weight substances having two or more double bonds capable of photopolymerization. An oligomer is defined herein as a relatively low molecular weight material composed of monomers. Oligomers are generally liquid at room temperature.

Suitable multifunctional vinyl oligomers include, for example, (meth)acrylate functionalized polyethers, (meth)acrylate-terminated polyesters, polyesters containing terminal vinyl unsaturation, and the like. Specific examples of suitable multifunctional vinyl oligomers include diacrylates of poly(ethylene oxide) polyol and acrylated epoxy compounds, such as acrylated Bisphenol A.

Multifunctional vinyl oligomers generally exhibit lower functionality than multifunctional vinyl monomers and are less prone to produce crosslinking in the polymeric coating during the first exposure step. If the coating is substantially or significantly crosslinked during the first exposure this will inhibit development of the image in the polymerized coating. Multifunctional vinyl oligomers having a functionality of 0.3 equivalents per one hundred grams, or less, are preferred.

Multifunctional vinyl oligomers having a functionality greater than 0.3 equivalents per one hundred grams can also be used in the photosensitive coating composition at concentrations of no more than 25 percent by weight.

Examples of useful multifunctional oligomers are Uvithane 783 acrylated urethane, a trademarked product of Morton Thiokol Inc., and Celrad, 3700 an acrylated ester of bisphenol A epoxy resin, a trademarked product of Celanese Specialty Resins Co. Uvithane 783 containing about 0.17 to about 0.21 functional equivalents per 100 grams is the most preferred multifunctional vinyl oligomer.

## Multifunctional Vinyl Monomers

"Multifunctional vinyl monomers" as used herein refers to monomers having two or more non-conjugated vinyl groups attached to a low molecular weight molecule such as for example a single benzene ring, a difunctional of polyfunctional alcohol or acid and the like. Examples of suitable multifunctional vinyl monomers include divinyl benzene, divinyl adipate, trimethylol propane, triacrylate, hexanedioldiacrylate and the like.

Multifunctional vinyl monomers typically contain more than 0.3 functional equivalents per 100 grams. If multifunctional vinyl monomers are present in large proportions the coating may be significantly crosslinked during the free-radical polymerization. Therefore, in processes that initiate the free-radical material in the first radiation exposure step, multifunctional vinyl monomer preferably represent 25 percent, or less, by weight of the coating composition. In both multifunctional monomers and multifunctional oligomers having functionality greater than 0.3 milliequivalents per 100 grams are present their combined weight should preferably be no more than 25% of the total composition.

## Monofunctional Vinyl Monomers

A "monofunctional vinyl monomer" as used herein refers to a vinyl monomer having only one carbon-carbon double bond responsive to a free radical initiated reaction. Examples of monofunctional vinyl monomers include styrene, alpha-methyl styrene, ring substituted styrenes, vinyl esters, acrylonitrile, methacrylonitrile, acrylic acid, methacrylic acid, acryloxy propionic acid, and cyclohexyl acrylate or methacrylate. Esters of acrylic, methacrylic or acryloxy propionic acid, acrylamide or methacrylamide, can also be used, as well as cyclic and bicyclic ester monomers such as bornyl and fenchyl acrylates, dicyclopentyloxy ethyl acrylate or methacrylate. Functionalized derivatives of such monofunctional vinyl monomers such as for example hydroxypropyl acrylate, alkoxyalkyl acrylates and the like may also be employed as the monofunctional vinyl monomer.

Monofunctional vinyl monomers which are not volatile under cure conditions are preferred because of health considerations as well as to prevent loss of material from the final coating by vaporization. Monomers that cure rapidly upon exposure to actinic radiation are also preferred. The volatility limit for the monofunctional vinyl monomers is directly related to the desired curing temperatures employed in the process, the amount of heat evolved upon curing and the thickness of the coating. It is preferred to utilize monofunctional vinyl monomers with boiling points of at least about 150°C; however, monofunctional vinyl monomers having boiling points below about 150°C can be used as minor components without serious adverse effects.

The preferred monofunctional vinyl monomers include acrylate of methacrylate esters. Hydrophilic monofunctional vinyl monomers, such as acid monomers, are less preferred as the resulting polymerized material may swell in humid atmospheres even after the two stage curing is completed.

A particularly preferred monofunctional vinyl comonomer useful in the liquid photosensitive composition is caprolactone acrylate, such as Tone M-100 a trademarked product of Union Carbide Corporation. This monomer is described in U.S. Patent 4,525,258 as an adduct of hydroxyethyl (meth)acrylate having one to ten units of caprolactam. Tone M-100 has acrylate functionality for copolymerization with other vinyl monomers and hydroxyl functionality for reaction with epoxides. Accordingly, Tone M-100 can provide connection between the vinyl polymerized multifunctional vinyl oligomer and the epoxy resin. In addition, Tone M-100 has been found to compatibilize the other vinyl monomers or oligomers, such as for example, isobornylacrylate, with the epoxy resin in the liquid photosensitive composition. In the absence of such a compatibilizing monofunctional vinyl comonomer, a liquid photosensitive coating composition may separate into phases upon standing requiring remixing prior to use. Tone M-100 has also been found to assist in the adhesion of the polymer coating to a substrate (e.g., copper) which is particularly useful if the photosensitive coating composition is to be used as a solder mask. In selecting a formulation for a particular end use one should bear in mind that increasing the level of Tone M-100 to improve adhesion of photosensitive coating may reduce the scratch resistance of the final crosslinked polymer.

The polymers formed from monofunctional vinyl monomer reactants may crosslink to some degree upon exposure to ultraviolet radiation. This partial crosslinking is not desirable for the B-stage coating, but can be tolerated provided that it does not result in an excessively crosslinked coating which cannot be removed from the surface using developers. This partial crosslinking is generally considered to be the result of chain transfer and becomes more pronounced with higher boiling monomers having additional sites on the pendant side chains. We have found that isobornyl acrylate (IBOA) is a preferred monofunctional vinyl monomer because it unexpectedly does not become involved in excessive crosslinking reactions in the liquid composition when it is exposed to ultraviolet radiation. In order to vary the hardness of the final coating isobornyl acrylate can be employed with isobornyl methacrylate.

PROPORTIONS OF FREE-RADICAL POLYMERIZABLE MATERIAL

The free-radical polymerizable material preferably comprises from 10% to 80% of the total composition by weight. More preferably the free radical polymerizable material comprises from 20% to 70% of the total composition by weight, and even more preferably the free radical polymerizable material comprises from 30% to 60% of the total composition by weight.

The relative proportions of the different elements within the free radical polymerizable material can vary widely.

A monofunctional vinyl monomer or multifunctional vinyl oligomer may each constitute 100 percent of the free-radical polymerizable material by weight. However, the free-radical polymerizable material may include both multifunctional vinyl oligomer and monofunctional vinyl monomer. The mixture of these two components provides a balance of the advantages of these two materials. The oligomers maintain the viscosity of the formulation and may prevent it from being two thin for some application techniques. If used alone, multifunctional vinyl oligomers may be too viscous. The presence of monofunctional monomer may help to reduce viscosity and allow the mixing of the formulation without the need for heating. The oligomers also may aid in compatibilization with epoxy resin, and can increase the polymerization rate of the vinyl groups by the well-known gel effect (R.W. Lenz, Organic Chemistry of Synthetic High Polymers, Interscience, New York, 1967, pp. 356-359.) The oligomers may also aid in adhesion of the polymer to substrate surfaces.

The following concentrations refer to the amount of oligomer or monomer per one hundred parts by the total photosensitive coating composition including the epoxy resin and photoinitiators.

The preferred amount of multifunctional vinyl oligomer having functionality no more than 0.3 milliequivalents per 100 grams is from about 5 to about 35 percent by weight of the total composition. The preferred amount of monofunctional vinyl monomer is from 12 to 70 percent by weight of the total composition.

The combined amount of multifunctional vinyl oligomer having functionality greater than 0.3 milliequivalents per 100 grams and multifunctional vinyl monomers is 0 or up to 25 percent, preferably less than 5%, by weight of the total composition.

## Second Reactive System: Epoxy Resins

The second reactive system contains epoxy resin. The preferred epoxy resins useful in this invention range from low molecule weight molecules containing two reactive epoxy groups to oligomers of higher molecular weight with two, three, four, or more epoxy groups available for further reaction. If desired, more than one epoxy resin can be used. Resins which have a functionality of from about 3 to about 4 (average number of epoxy functional groups per molecule), and epoxy equivalent weight of about 160 to about 230 are more preferred.

The most preferred epoxy resin is an epoxy novolak with 176-181 epoxy equivalent weight, and a functionality of 3.6. Such a material is supplied by Dow Chemical Co. as D.E.N. 438. Epoxy novolaks lower in functionality (those having lower molecular weight) than D.E.N. 438, such as D.E.N. 431 (functionality 2.2 vs. 3.6), are not as solvent resistant after the second irradiation step. Epoxy novolaks higher in functionality are less compatible with monomers such as isobornyl acrylate, and the liquid formulation is more likely to separate into two phases.

Two epoxy resins from Dow comprising the triglycidylether of tris(hydroxyphenyl) methane isomers and higher oligomers are also preferred: Tactix 742, 162 epoxy equivalent weight, and XD 9053.01, 220 epoxy equivalent weight.

Cycloaliphatic epoxides, such as 3,4-epoxycyclohexylmethyl-3,4-epoxycyclohexane carboxylate, Cyracure UVR-6100, Cyracure UVR-6110, and ERL-4221, from Union Carbide Corp. are generally considered to be the most responsive epoxy to curing with initiators such as General Electric's UVE-1014 described hereinafter. However, cycloaliphatic epoxides are less preferred in the process of the invention, owing to more tack after the first radiation exposure. More irradiation eliminates the tack, but then solvent development is more difficult.

Diglycidyl ethers of bisphenol A are still less preferred because they do not cure as well as cycloaliphatic epoxides and epoxy novolaks by cationic initiation.

The epoxy component is present preferably at about 20 to about 80 percent by weight of the total formulation, more preferably 25 to about 40 weight percent.

## Photoinitiators

The photoinitiators used in the photosensitive composition of the invention are free radical photoinitiators and cationic photoinitiators; at least one free radical photoinitiator and at least one cationic photoinitiator must be used.

The photoinitiators are selected so that only one of said reactive systems is effectively responsive to radiation at certain defined wavelengths.

The literature contains extensive listings of photoinitiators showing the wavelengths at which these initiators respond. If for a given photoinitiator, the effective wavelengths are not readily available in the literature they can be determined by examining the spectral absorbance of the photoinitiators.

The wavelengths emitted by various radiation sources are also known. Therefore one can select a source which emits radiation of certain wavelengths and select the photoinitiators so that only one of the reactive systems is effectively initiated by that radiation source.

The free radical photoinitiators must be capable of both absorbing ultraviolet radiation and producing free radicals. The free radical photoinitiators may operate by either breaking down upon absorption of the ultraviolet radiation into free radicals or may cause free radicals to form on another material in the formulation. Ultraviolet radiation sensitive free radical photoinitiators are well-known and commercially available. For example, (We have found that an equal weight mixture of 1-hydroxy cyclohexylphenyl ketone manufactured by Ciba-Geigy Corp under the trademark Irgacure 184 and 2,2-dimethoxy-2-phenyl acetophenone also manufactured by Ciba-Geigy Corp. under the trademark Irgacure 651 is particularly effective as the free radical photoinitiator in the liquid photosensitive composition of the invention). The free radical photoinitiator should preferably be present in the composition in an amount of from about 1 to about 10 parts per 100 parts by weight of the total composition and more preferably from 3 to about 5 parts per 100 parts by weight of the total composition. In a preferred embodiment, the free radical photoinitators absorb ultraviolet radiation above a certain wavelength, preferably 340 nanometers.

Cationic photoinitiators which do not significantly absorb ultraviolet radiation at the wavelength used in the free-radical initiation step, are employed in combination with the free radical photoinitiator to initiate the epoxy crosslinking reaction in the photosensitive film during the epoxy initiating step. Effective cationic photoinitiators include, for example, triaryl sulfonium hexafluoroantimonate, such as, General Electric Company's UVE-1014 and Union Carbide Corporation's Cyracure UVI-6974; triaryl sulfonium hexafluorophosphate, such as, General Electric Company's UVE-1016, Union Carbide Corporation's Cyracure UVI-6990, or 3M Company's FC-512; or diaryliodonium salts, such as 3M Company's FC-509. (We have found that UVE-1014 and UVI-6974 are most preferred since they do not absorb ultraviolet radiation above 360 nanometers). The cationic photoinitiator or mixture of cationic photoinitiators are preferably present at concentrations of from 0.8 to about 8 parts per 100 parts by weight of the photosensitive coating composition and more preferably from about 3 to about 5 parts per hundred parts by weight.

## Additives

The photosensitive coating composition may also contain other miscellaneous additives, such as fillers, as for example talc, to reduce cost and the degree of coating shrinkage. These additives are typically employed at amounts from about 10 to about 40 and preferably about 10 to about 30 weight percent of the total composition. Pigments or dyes may also be used in the composition so that the polymeric coating can be visually detected on the substrate. These pigments or dyes are typically present at a concentration of from about 0.2 to about 2 weight percent.

## Actinic Radiation

The process of the invention utilizes actinic radiation to cure the coating composition. Generally, ultraviolet radiation is preferred. Ultraviolet radiation is that portion of the electromagnetic spectrum having wavelengths from about 200 to about 400 nanometers. Suitable sources of ultraviolet radiation include carbon arcs, mercury vapor arcs, fluorescent lamps with phosphors emitting ultraviolet light, argon and xenon glow lamps, tungsten lamps, and photographic flood lamps. Mercury vapor arc lamps are preferred.

In a preferred embodiment a filter is used during the first radiation exposure step to prevent the passage of an effective amount of wavelengths that initiate one of the reactive systems.

The particular wavelength cut-off point of the filter must be consistent with the initiating wave lengths of the free-radical and cationic photoinitiators selected for a given process. For the examples demonstrated herein, a filter having a wavelength cutoff at 340 nm was used and is considered to be preferred.

Appropriate filters may be selected from those available from optical supply houses, or may be prepared by preparing films or castings of optically clear polymers containing UV absorbers selected to prevent passage of wavelengths shorter than the desired cut-off point. For example appropriate UV absorbers include substituted benzophenones, benzotriazoles, diphenylcyanoacrylates, hindered amines, and the like. These materials have known spectral characteristics, and useful filters can readily be prepared therefrom.

Alternatively first-stage cure may be accomplished by exposure to a light source which exhibits a narrow spectral emission, such as Sylvania F-20T12-BLB lamp or lamps, which emit a narrow band of actinic wavelengths between 300 and 420 nm, with a peak emission at 356 nm. As can be seen, even the "narrow band" emitting UV lights have a fairly broad spectral emission and the filter approach is therefore preferred. In a process which uses a narrow band radiation source without a filter in the first exposure step care must be taken to assure that the photoinitiator which is not initiated in the first step is substantially not responsive to the wavelengths actually emitted by the source, which may include wavelengths outside the spectral emission range represented by the manufacturer.

In some cases, it may be desirable to heat the coating to accelerate the photoinitiated cure for example to reduce tack. Exposure time will depend upon the types and proportions of compounds in the formulation. The type of light source, and the distance of the coating formulation from the light source.

Exposure time in the first step, where the filter is preferably used, is chosen to minimize tack while still allowing further processing of the coating, for example solvent development. More passes under the lamp(s) will tend to reduce tack, but may also make the material more difficult to remove when solvent developed. The duration of the second exposure step is selected to produce the desired final cure, for example to assure solvent resistance of the final coating.

Final cure may be completed by exposure to a conventional broad-band UV source, such as the RPG UV cure unit without filter described in Example 1. In addition, the coating may be optionally heated after the second step irradiation to complete the cure ("dark" cure) and improve adhesion. Aging at room temperature usually provides the same effect over a longer period of time.

## DESCRIPTION OF EMBODIMENT AS SOLDER MASKS, PHOTORESIST, CONFORMAL COATINGS

In fabricating electronic circuit boards a hard, tough, solvent resistant coating or film is formed on selected areas of a circuit board substrate, for example to create a solder mask. This coating, also called a resist, serves to protect the covered areas of the circuit board substrate during subsequent processing steps.

The inventive process may be utilized in the preparation of solder masks for circuit boards, where the two-step cure and solvent development results in protection of areas where soldering is not desired. The liquid photosensitive composition is applied for example to copper on fiberboard or glass/epoxy composite surface which has been previously etched to form a circuit pattern. A tack-free B-stage polymer, which can still be altered or repaired with solvent, is formed on the circuit board by exposure only to longer-wave length UV radiation. An advantage of the present process is that the mask may be placed directly on the tack-free surface, which eliminates any air gap necessitated by a wet or tacky coating and allows more fidelity in the reproduced image pattern. A solvent wash (development) removes the unmasked portion while the portion of the resin not covered by the mask remains as a permanent coating.

The two-stage dual photocure may also be utilized to form photoresists. By forming the B-stage polymer on the copper so exposed, and finally removing the cured resin in a development step, suitable copper connections having fine lines may be prepared.

A number of conventional techniques are used to apply the resist such as screen printing or photolithographical imaging.

In photolithographical imaging a pattern is transferred from a photomask onto a coating. First, a coating is applied to a substrate surface. The coating is selectively photopolymerized in a pattern, for example with actinic light applied through a photomask. A photomask contains a pattern which is made up of areas that are opaque to the exposing radiation and other areas that are transparent to the exposing radiation.

The photomask is positioned between the coated substrate and a source of exposing radiation. During exposure, the exposing radiation passes through the transparent areas on the photomask and contacts the coating. Those portions of the coating which align with the opaque portions of the photomask are not exposed to the radiation.

A photochemically induced reaction changes the solubility of exposed areas in a liquid (the developer). The more soluble areas are removed with the developer, leaving an image of the resist as a coating on the substrate surface. The image of the resist corresponds to the image on the photomask. The image of the resist can then be used as a mask or shield to protect the coated portions of the substrate during subsequent processing.

The photolithographic image is a discontinuous coating on a substrate; coated areas of substrate are interrupted by uncoated areas. In images having fine detail it is desirable that the coating image be highly resistant to the action of the developer. The solvent resistance of a given coating to the action of the developer can be increased by crosslinking the coating. Since crosslinked coatings are not readily soluble in or significantly swelled by the developer the strength of developer and duration of the development step is less critical.

The process can also be utilized to prepare conformal coatings for circuit boards and other irregular shaped objects. It may also be used to produce shaped images, wherein appropriate sharp images are formed from the polymer fully exposed to the radiation after solvent removal of the polymer uncured after masking in the first photoexposure. An advantage of the two-step process is that the first-stage coating may be removed to allow reworking of the electrical components and circuitry.

Another embodiment of the present invention for producing a two-stage cure is in the preparation of radiation curable coatings that may be repaired before final cure, wherein the first stage cure solidifies the coating, but allows for repairs, such as correction of incomplete coverage, poor leveling, blistering, and the like.

The invention will now be further described by reference to the following examples.

<center>EXAMPLES</center>

<center>**Description of Experimental Procedures**</center>

### A. Substrate

The substrate was Copper-clad FR-4 (fiberglass embedded in epoxy resin) circuit board. The copper surface was cleaned with a green nylon scouring pad similar to Scotchbrite pads. The copper surface was then sequentially rinsed with tap water, wiped dry, sprayed with acetone, rinsed with distilled water, and dried at 50°C.

### B. Formulations

Formulations are described in the examples. Unless otherwise stated, all proportions are weight percent.

### C. Application

The formulations described in the examples were coated onto 152 mm x 102 mm (6 in x 4 in) circuit boards using a Gardco 8-path wet film applicator, 2 mil path depth. (Paul N. Gardner Co., Inc., Lauderdale By-The-Sea, Florida).

### D. UV Irradiation Steps

The UV radiation exposures were performed through a Model QC 1202AN3DH PPG Industries UV Processor (RPC Equipment, Plainfield, Illinois). Running conditions appear in the examples. When the filter was used, it was supported 5 mm above the sample by Velcro strips as spacers. The filter can be made by adding an absorber to acrylic plastic sheet which is otherwise transparent to radiation down to about 280-290nm. A useful absorber is Uvinul N-35 (GAF Corporation), which is 1,1-diphenyl-2-cyano-2-carboethoxyethylene. As an example, 0.125 inch cast acrylic sheet which contains 0.05% Uvinul N-35 allows penetration of essentially no UV radiation shorter than 340 nm.

### Test Procedures

Solvent Development:

The test sample was rubbed lightly with cheesecloth soaked in methylethylketone (MEK) to wet the coating. In the case of coatings that could be developed, the MEK penetrated to the coating-substrate interface and propagated blistering through those areas of material which had been exposed only to filtered radiation. The blistered material was removed with continued rubbing, somewhat more vigorous than initially. The material was removed as small pieces; very little if any was truly soluble in MEK.

Thermal Shock Resistance -- Solder Bath:

A Model 75T-650 watts Electrovert soldering pot was used with 60/40 solid solder. The solder was maintained at 288° C and the sample was floated ont he surface, printed side down, for 20 seconds.

Cross Hatch Adhesion:

ASTM D3359-78 Method B--Cross Cut Tape Test was performed using Scotch 810 tape; 6 cuts were made, 2 mm apart.

<center>7</center>

### Example 1

#### Coating Exposed first Through Sub-340nm Cutoff Filter

The following materials were blended:

| Component | % |
|---|---|
| Isobornyl acrylate, Rohm & Haas | 40 |
| Tone M-100 caprolactone acrylate, Union Carbide | 15 |
| Uvithane 783 acrylated urethane, Morton Thiokol | 5 |
| D.E.N. 438 epoxy novolak, Dow Chemical | 32 |
| Irgacure 184 photoinitiator, Ciba-Geigy | 2 |
| Irgacure 651 photoinitiator, Ciba-Geigy | 2 |
| UVE = 1014 triarylsulfonium salt cationic photoinitiator, General Electric | 4 |

Coating of substrate was carried out according to the general description. The coated sample was first exposed to ultraviolet radiation in the PPG UV cure unit, with two lamps set on "full" (7.9 kwatt/m) intensity under nitrogen. A filter was suspended above the sample to cut off radiation of wavelengths shorter than 340 nm. The sample was passed through the unit 4 times at a speed of 254 mm/sec (50ft/min). At the conclusion of these irradiations the coating exhibited a slight tack which diminished with time. The coating was heated to 50°C for 10 minutes to eliminate the tack more quickly.

A photomask was placed on the coating and the sample was then passed through the PPG UV cure unit. The photomask pattern had nine circles cut through a metal block a background. The PPG UV cure unit had two lamps, set on "high" (11.8 kwatt/m). The samples were passed through the unit 6 times at a speed of 254 mm/sec (50ft/min.) The sample was then heated to 170°C for 10 seconds.

The coating was developed by rubbing lightly with cheese-cloth soaked in methyl ethylketone at room temperature. After about a minute, the MEK penetrated to the substrate/coating interface and propagated blistering through the material that was exposed only to filtered radiation (areas masked during second exposure). Continued rubbing, somewhat more vigorous than initially, removed the blistered material. The circles that were irradiated in the second step without the filter were not removed.

In a cross hatch adhesion test, tape removed none of the developed coating.

The developed coating was floated on a solder bath at 288°C for 20 sec. No blisters or delamination occurred on repeated challenges on the solder bath.

A two-phase structure was readily apparent on electron microscopic examination of the final coating. The particle size range of the dispersed particles was broad, 100 nm to nearly 2 microns across. Many appeared to be agglomerates of roughly 300 nm particles.

### Comparative Example A

#### No Filter During First Exposure

Example 1 was repeated exactly except that the first exposure was done without a filter. When the sample was rubbed with MEK all of the coating was removed. The coating was not crosslinked sufficiently to prevent transport of solvent to the interface. The solvent penetrated to the substrate surface, spread under substantially all of the coating and delaminated it.

In another experiment, the coating received 8 passes at the "b" stage (total of 12 passes). This time none of the coating was removed by the MEK. The images could not be developed. All of the coating was crosslinked sufficiently to prevent transport of solvent to the interface.

This example demonstrates that regulating the duration of exposure to a source having the same wavelength of emission first without and then with a mask did not provide an imaging process.

## Example 2

## VARIED NUMBER OF EXPOSURES IN FIRST STEP WITH FILTER

Example 1 was repeated except that the number of passes in the first irradiation step with the filter was varied. With 8 and 12 passes, good, sharp images were obtained.

This example demonstrates that a wide range of radiation exposures in the first stage with the filter ("a") 4, 8 and 12 passes allow good images to be obtained.

With a high number of passes through the unit (30), the "a" stage material was difficult to remove. The duration and intensity of the solvent development required to remove the highly cured "a" stage also removed portions of the "b" stage; some circles were removed completely.

The coatings above were heated to 160° C for 30 minutes following solvent development. Cross hatch adhesion of the coating was excellent; 0% was removed.

## Example 3

## OLIGOMER IMPROVES ADHESION

This example demonstrates the value of an oligomer such as Uvithane 783 in improving adhesion to copper.

Example 1 was followed except that Uvithane 783 was eliminated form the formulation and replaced by the same weight of isobornyl acrylate.

The coating could not be developed with MEK without damage. During the 160° C/30 min. bake, much of the coating spontaneously delaminated from the copper surface. This demonstrates poorer adhesion.

## Example 4

## HEAT CURE NOT REQUIRED

Example 1 was repeated except that the sample was not baked for 160° C/30 min.. Instead it was aged overnight at 23°C. Only 4% of the coating was removed in the cross hatch adhesion test. This example demonstrates that baking is not necessary.

## EXAMPLE 5

## POLYOLS

This example demonstrates that a polyol such as Tone 305 is less desirable than Tone M-100, particularly with respect to adhesion. Polyols are frequently used as coreactants for epoxy resins. In formulations where adhesion is important the use of polyol reactants may be a disadvantage.

The formulation of Example 1 was changed by substituting Tone 305 for Tone M-100. Tone 305 is a polycaprolactone triol, approximately 540 molecular weight, available from Union Carbide Corporation.

The following formulation was prepared:

| Component | % |
|---|---|
| Isobornyl acrylate | 40 |
| Tone 305 | 15 |
| Uvithane 783 acrylated urethane | 5 |
| D.E.N. 438 epoxy novolak | 32 |
| Irgacure 184 photoinitiator | 2 |
| Irgacure 651 photoinitiator | 2 |
| Cyracure UVI-6974 triarylsulfonium salt cationic photoinitiator | 4 |

The cure schedule was the same as in Example 1.

The images were somewhat more difficult to develop and all of the coating was removed in the cross hatch adhesion test.

Example 6

CYCLOALIPHATIC EPOXIDE LESS DESIRED THAN EPOXY NOVOLAK

This example demonstrates that a cycloaliphatic epoxide did not produce as good a balance of solvent developability vs. hardness as D.E.N. 438.

Example 1 was repeated except that Cyracure 6110, a cycloaliphatic epoxide from Union Carbide Corp., was substituted for D.E.N. 438. After the first stage irradiation with the filter, the coating remained tacky with heating 50°C for 10 minutes. In Example 1 with D.E.N. 438, this heating eliminated tack.

The experiment was repeated with the coating exposed to 10 passes instead of 4 at the first stage. Heating at 50°C for 10 minutes eliminated tack. The masked areas were difficult to remove during solvent development and parts of the desired images were removed.

Example 7

MULTIFUNCTIONAL VINYL MONOMER SUBSTITUTED FOR ALL OR PART OF MONOFUNCTIONAL VINYL MONOMER

A formulation was prepared as in Example 1 except that 1,6-hexanedioldiacrylate was substituted for some or all of the isobornylacrylate. The following formulations were prepared:

| | Parts | | | |
| | 7(a) | 7(b) | 7(c) | 7(d) |
|---|---|---|---|---|
| 1,6-hexanediol diacrylate | 5 | 15 | 25 | 40 |
| Isobornyl acrylate | 35 | 25 | 15 | -- |
| Tone M-100 | 15 | 15 | 15 | 15 |
| Uvithane 783 acrylated urethane | 5 | 5 | 5 | 5 |
| D.E.N. 438 epoxy novolac | 32 | 32 | 32 | 32 |
| Irgacure 184 photoinitiator | 2 | 2 | 2 | 2 |
| Irgacure 651 photoinitiator | 2 | 2 | 2 | 2 |
| Cyracure UVI-6974 cationic photoinitiator | 4 | 4 | 4 | 4 |

The cure schedule was the same as in Example 1. The coatings comprising 5 and 15 parts 1,6-hexanediol diacrylate [7(a) and (b)] were easily developed with methylethylketone and images were sharp. The images of the coating with 25 parts 1,6-hexanediol diacrylate [7(c)] were slower to develop with MEK but were sharp.

The coating containing 40 parts 1,6-hexanediol diacrylate, [7(d)] could not be developed with methylethylketone in the manner of Example 1 (i.e., the material irradiated through the filter was not removed). Apparently, too much crosslinking occurred.

All of the 7(a) and 7(c) coatings as well as 72% of the 7(b) coating were removed in the cross hatch adhesion test. The use of increased levels of 1,6-hexanediol diacrylate apparently reduced adhesion of the coating to copper.

This example demonstrates that when a multifunctional vinyl monomer, 1,6-hexanedioldiacrylate (SR-238), Arco Chemical Co.) was used as the sole vinyl monomer, the images were not developable. Images can be developed when lower levels of this monomer are present. Higher multifunctional vinyl monomer appears to impair adhesion to the copper substrate.

EXAMPLE 9

HIGH AND LOW EPOXY CONTENT

The following ingredients were mixed:

| Component | Parts | | | | |
|---|---|---|---|---|---|
| | 8(a) | 8(b) | 8(c) | 8(d) | 8(e) |
| Isobornyl acrylate | 62 | 17 | 9 | 6 | -- |
| Tone M-100 | 15 | 10 | 3 | 1 | -- |
| Uvithane 783 acrylated urethane | 5 | 5 | 5 | 2 | -- |
| D.E.N. 438 epxoy novolak | 10 | 60 | 75 | 85 | 86.6 |
| Irgacure 184 photoinitiator | 2 | 2 | 2 | 1 | -- |
| Irgacure 651 photoinitiator | 2 | 2 | 2 | 1 | -- |
| Cyracure UVI-6974 triarylsulfonium salt cationic photoinitiator | 4 | 4 | 4 | 4 | 4.3 |
| methyl ethyl ketone | -- | -- | -- | 5 | 9.1 |

Comparative Formulation (8a), which contained 10% D.E.N. 438 did not produce sufficiently cross-linked materials in unmasked areas. Three of the nine circles were removed completely on development. The others were partially removed.

Formulation 8(b) with 60% and formulation 8(c) with 75% D.E.N. 438, produced coatings that were easily developed and produced sharp images. In the tape adhesion test, 48% of the 8(b) coating (60% D.E.N. 438) was removed and 100% of the 8(c) coating (75% D.E.N. 438) was removed.

In Formulations 8(d) and 8(e), methylethyl ketone was used to lower viscosity for ease of coating. After drawdown, the coating was heated 50° C/10 min. to remove the MEK solvent before irradiation.

In Formulation 8(d), (85% D.E.N. 438), the coating could not be developed (i.e., no removal of material that had been irradiated through the filter). Formulation 8(e) comprised only D.E.N. 438, UVI-6974, and methyl ethyl ketone.

D.E.N. 438 represents 95% of this formulation excluding solvent. Images could not be developed in the 8(e) coating. The data indicate that the percentage of D.E.N. 438 was too high in the 8(d) and 8(e) coatings.

It appears that some polymerization of the epoxy novolak occurred int he first irradiation through the filter. The filter apparently did not eliminate all radiation that would activate the cationic photoinitiator. This demonstrates that some minor degree of polymerization of the epoxy novolak occured in the first through the filter. In coatings which contain more free-radical polymerized material, the difference between material irradiated with and without the filter was sufficient for good development.

Adhesion was poor at the higher levels of D.E.N. 438: 75%, 85% and 95%. In the cross hatch adhesion test, 100% of the coating was removed by the tape.

This example demonstrates the limitations of formulations which use extremely low and high levels of D.E.N. 438.

## Example 9

2-(2-ethoxyethoxy) ethyl acrylate

## USED AS MONOFUNCTIONAL VINYL MONOMER

Example 1 was repeated except that 2-(2-ethoxyethoxy)ethyl acrylate was substituted for isobornyl acrylate. Sharp images were obtained on development with methyl ethyl ketone. None of the coating was removed by tape in the cross hatch adhesion test.

This example demonstrates the utility of 2-(2-ethoxyethoxy)ethyl acrylate (SR-256, Arco Chemical Co.) as a monofunctional vinyl monomer.

## COMPARATIVE EXAMPLE C

### FORMULATION WITHOUT EPOXY

This example demonstrates the need for the epoxy resin in order to obtain solvent resistance.
The following formulation was prepared:

| Component | Parts |
|---|---|
| Isobornyl acrylate | 66 |
| Tone M-100 | 25 |
| Uvithane 783 | 5 |
| Irgacure 184 | 2 |
| Irgacure 651 | 2 |

The cure schedule was the same as in Example 1. The coating remained tacky after heating 50°C for 10 minutes following irradiation through the filter. Cross hatch adhesion was good; the tape removed none of the coating after further irradiation without the filter. The coating was not solvent resistant.

### Example 10

### HIGH OLIGOMER PROPORTION

Example 1 was repeated except that Celrad 3700 and Uvithane 783 were substituted for part or all of the isobornyl acrylate.
The following formulations were prepared:

| | Parts | | | |
|---|---|---|---|---|
| | 10(a) | 10(b) | 10(c) | 10(d) |
| Celrad 3700[1] | 30 | 45 | 55 | -- |
| Isobornyl acrylate | 10 | 10 | -- | 20 |
| Tone M-100 | 15 | -- | -- | 15 |
| Uvithane 783 acrylated urethane | 5 | 5 | 5 | 25 |
| D.E.N. 438 epoxy novolac | 32 | 32 | 32 | 32 |
| Irgacure 184 photoinitiator | 2 | 2 | 2 | 2 |
| Irgacure 651 photoinitiator | 2 | 2 | 2 | 2 |
| Cyracure UVI-6974 cationic photoinitiator | 4 | 4 | 4 | 4 |

Celrad 3700 = acrylated ester of bisphenol A epoxy resin, Celanese.

Celrad 3700 is essentially solid at room temperature (2.3 Pa s at 65°C). D.E.N. 438 is also essentially solid (35 Pa s at 52°C). Formulations 10(b) and 10(c) were heated to 70° C to reduce viscosity in order to dissolve Irgacure 651 and Irgacure 184 and mix the formulations. The formulations were also heated to 70° C in order to reduce viscosity sufficiently for coating.
The cure schedule was the same as in Example 1.
After irradiation through the filter and heating 50°C for 10 minutes all coatings were very slightly tacky. This is a slight disadvantage of using a high oligomer proportion. Solvent development with MEK was somewhat slower and required increasingly more vigorous rubbing as the proportion of Celrad 3700 in the coating increased. Sharp images were produced.
In the crosshatch adhesion test, the tape removed none of the 10(a) and 10(d) coatings, but all of the 10(b) and 10(c) coatings. Thus adhesion to copper was not as good when high proportions of isobornyl acrylate were replaced by Celrad 3700.

The high formulation viscosity and less desirable adhesion to copper make 10(b) and 10(c), formulations high in Celrad 3700 multifunctional oligomer, less preferred.

This example demonstrates that a multifunctional oligomer can be used in high proportions, even as the sole vinyl functional component of the formulation.

## Comparative Example E

Example 1 was repeated except that the filter was Oroglas UF-3 acrylic sheet (Rohm and Haas Co.), which is prepared with a UV absorbing system which cuts off radiation shorter than 390 nm. The liquid formulation remained liquid when irradiated through this filter. The photoinitiators used, Irgacure 184 and Irgacure 651 do not absorb radiation above 390 nm.

This example demonstrates the UV light having wavelengths shorter than 390 nm is required when the cationic photoinitiators of Example 1 are used. It also demonstrates that polymerization was not substantially initiated by heat from the lamps.

## Example 11

### TONE M-100 IMPROVES ADHESION

The following formulation was prepared.

| Component | Parts |
|---|---|
| Isobornyl acrylate | 48 |
| Uvithane 783 | 5 |
| D.E.N. 438 | 39 |
| Irgacure 184 | 2 |
| Irgacure 651 | 2 |
| UVE-1014 | 4 |

The cure schedule was the same as in Example 1. The formulation split into two phases on standing, which is undesirable. It was mixed immediately before coating in order to obtain a uniform coating.

Development with methyl ethyl ketone was easy and edges sharp. All of the coating was removed by the tape in the cross hatch adhesion test. With Tone M-100 present, none of the coating was removed (Example 1).

This example demonstrates that including Tone M-100 in the formulation improves adhesion.

## Example 12

### SUBSTITUTING TONE M-100

Example 1 was repeated except that some or all of the isobornyl acrylate was replaced by Tone M-100. The following formulations were prepared:

|  | Parts | |
|---|---|---|
|  | 15(a) | 15(b) |
| Isobornyl acrylate | 30 | -- |
| Tone M-100 | 25 | 55 |
| Uvithane 783 acrylated urethane | 5 | 5 |
| D.E.N. 438 epoxy novolac | 32 | 32 |
| Irgacure 184 photoinitiator | 2 | 2 |
| Irgacure 651 photoinitiator | 2 | 2 |
| Cyracure UVI-6974 cationic photoinitiator | 4 | 4 |

The cure schedule was the same as in Example 1.

The 15(a) coating became translucent when irradiated, presumably due to phase separation of D.E.N. 438. The 15(b) coating remained clear during and after irradiation.

Sharp images were obtained on development of both coatings with methyl ethyl ketone.

All of the 15(a) coating and none of he 15(b) coating was removed in the cross hatch adhesion test. Apparently, adhesion is not as good at intermediate levels of Tone M-100. At the high proportion of Tone M-100 (55 parts), the greater flexibility of the coating and higher proportion of hydroxyl groups may have contributed to the good adhesion.

This example demonstrates the use of higher proportions of Tone M-100 (caprolactone acrylate) than in Example 1.

**Claims**

1. A process for producing photocured coatings in a two-step exposure comprising;

a) depositing as a coating on a substrate a composition which contains:

a first reactive system comprising a free-radical polymerizable material and a photoinitiator of free radical polymerization, and

a second reactive system comprising a cationic polymerizable epoxy resin and a photoinitiator of cationic polymerization;

b) exposing all or portions of said coating to a first actinic radiation in an amount effective to initiate a desired level of reaction in one reactive system while not substantially reacting the other reactive system, and;

c) subsequently exposing all or portions of said coating to a second actinic radiation, different than said first actinic radiation, in an amount effective to initiate a desired level of reaction in said other reactive system.

2. The process of claim 1 which further comprises performing optional step (d) after step (b) and before step (c), step (d) comprising repairing the coating.

3. A process as claimed in claim 1 which comprises;

a) depositing as a coating on a substrate a composition which contains:

a first reactive system comprising a free-radical polymerizable material and a photoinitiator of free radical polymerization, and

a second reactive system comprising a cationic polymerizable epoxy resin and a photoinitiator of cationic polymerization;

b) exposing said coating to a first actinic radiation in an amount effective to initiate a desired level of reaction in one reactive system while not substantially reacting the other reactive system to produce a B-stage coating and;

c) exposing portions of said B-stage coating to a second radiation, different than said first actinic radiation, in an amount effective to initiate reaction in said other reactive system to produce an image of cured coating;

d) developing said image by removing the portions not exposed to said second radiation.

4. The process on any one claims 1 to 3, wherein said actinic radiation is ultraviolet radiation.

5. The process of any one of claims 1 to 4 wherein said first actinic radiation substantially does not include wavelengths shorter than 340 nanometers and said second actinic radiation includes an amount of said wavelengths effective to initiate the desired level of reaction in the other reactive system.

6. The process of any one of claims 1 to 4 wherein said first and second actinic radiation are generated by the same source and said first radiation includes less than the full spectral emission of said source.

7. The process of claim 6 wherein exposing step (a) comprises directing actinic radiation through a wavelength cutoff filter to produce said first radiation.

8. The process of claim 7 wherein said filter blocks the passage of wavelengths shorter than 340 nanometers.